# FASCICULE DE BREVET EUROPEEN

(11) **EP 3 087 401 B1**
(45) Date de publication et mention de la délivrance du brevet: **17.07.2019**
(21) Numéro de dépôt: 14825329.7
(22) Date de dépôt: 19.12.2014
(51) Int. Cl.: G01R 31/00, G06F 11/36, B64F 5/00

(54) **SYSTÈME DE SIMULATION ET DE TEST**
TEST- UND SIMULATIONSSYSTEM
TEST AND SIMULATION SYSTEM

(30) Priorité: 24.12.2013 FR 1363540
(43) Date de publication de la demande: 02.11.2016
(73) Titulaire: AIRBUS (SAS), 31700 Blagnac (FR)
(72) Inventeur: AFONSO, George, F-69100 Villeurbanne (FR); GODARD, Wenceslas, F-31000 Toulouse (FR); BEN ATITALLAH, Rabie, F-59300 Famars (FR); DEKEYSER, Jean-Luc, F-62840 Sailly Sur La Lys (FR)
(74) Mandataire: Gicquel, Olivier Yves Gérard
(86) Numéro de dépôt international: PCT/EP2014/078882
(87) Numéro de publication internationale: WO 2015/097105

(56) Documents cités:
- FR-A1- 2 970 792
- US-A1- 2010 174 522
- US-A1- 2012 290 692
- AFONSO G ET AL: "An efficient design methodology for hybrid avionic test systems", EMERGING TECHNOLOGIES AND FACTORY AUTOMATION (ETFA), 2010 IEEE CONFERENCE ON, IEEE, PISCATAWAY, NJ, USA, 13 septembre 2010 (2010-09-13), pages 1-4, XP031937139, DOI: 10.1109/ETFA.2010.5641195 ISBN: 978-1-4244-6848-5
- GUANGDA LIU ET AL: "Architecture Development of Research Flight Simulator Based on COTS", INFORMATION ENGINEERING AND COMPUTER SCIENCE, 2009. ICIECS 2009. INTERNATIONAL CONFERENCE ON, IEEE, PISCATAWAY, NJ, USA, 19 décembre 2009 (2009-12-19), pages 1-4, XP031589038, ISBN: 978-1-4244-4994-1

## Description

### Domaine de l'invention

La présente invention se rapporte au domaine technique général des outils de simulation et de tests système dans le domaine de l'aéronautique. Elle propose un système de simulation et de test basé sur un nouvel environnement unifié et générique pour la simulation et le test plus particulièrement adapté pour les systèmes avioniques et propose un modèle d'exécution dynamique pour un environnement unifié et générique de simulation et de test dédié à l'avionique.

### Arrière plan technologique

La simulation et le test sont deux phases essentielles du cycle de production industriel. Depuis toujours, les outils de simulation et de test utilisés dans le cycle de vérification et de validation avionique ont été découplés bien que ces deux phases partagent des modèles similaires. De même, dans les pratiques industrielles d'aujourd'hui, des environnements distincts sont utilisés pour la simulation et le test qui sont considérés comme deux domaines d'expertise différents.

Ceci s'oppose à la mutualisation des moyens matériels et logiciels déployés sur les bancs d'intégration de test et les simulateurs servant aux qualifications d'équipements embarqués sur des aéronefs, par exemple des hélicoptères.

En outre, la disparité entre les moyens de simulation et de test ne favorise pas un passage aisé entre les différentes phases de vérification et de validation qui utilisent un simulateur complet n'utilisant que des modèles virtuels et des équipements simulés puis un banc de test unitaire où un seul équipement est testé et enfin un banc d'intégration où les modèles sont remplacés au fur à mesure de leur disponibilité par l'équipement réel correspondant.

Par ailleurs, les procédés actuels de test avionique et les architectures des bancs associées ne répondent pas au problème de validation du système complet au sol, l'intégration d'équipements logiciels et matériels restant une difficulté technologique.

Enfin, les moyens d'essai actuels étant dédiés à un équipement d'un appareil spécifique, aucune réutilisation de bancs n'est envisagée pour le test d'équipements différents pour un même appareil ni pour le test d'un même équipement sur des appareils différents.

En terme économique, ceci se traduit par un coût important, un effort de développement considérable et un délai de mise en oeuvre assez long des tests et donc des équipements et appareils.

Pour les hélicoptères notamment, les moyens de simulation et de test stratégiques ont une influence importante sur la mise à disposition de nouveaux produits sur le marché.

Bien qu'apparaissent depuis quelque temps des premières solutions spécifiques afin de faire converger les outils de simulation et de test, les solutions antérieures proposées demeurent limitées sur les aspects suivants :
L'architecture des bancs d'intégration de tests qui sont aujourd'hui dédiés pour chaque gamme d'aéronef et pour chaque type d'équipement sous test ne sont pas génériques. Ceci est dû à l'utilisation des cartes de traitement ou d'Entrées/Sorties (E/S) de technologies spécifiques.

Les bancs d'intégration actuels ne permettent pas d'adapter l'environnement de tests lors du passage d'un modèle spécifique, par exemple pilote réel vers pilote automatique, d'une gamme d'hélicoptère au même modèle d'une autre gamme. Par ailleurs, l'assemblage de composants pour lancer un nouveau projet de simulation ou de test se fait hors-ligne.

Il n'existe pas de modèle d'exécution ouvert: les environnements de simulation et de test existants ne permettent pas l'échange de modèles car les modèles d'exécution correspondants sont fortement liés aux technologies utilisées.

Les bancs de test utilisant des cartes dédiées ne sont pas évolutifs et deviennent obsolètes si les cartes de traitements ou d'E/Ss utilisées ne sont plus à jour.

Un exemple de système de test reconfigurable offrant une certaine modularité et utilisant des ressources génériques reliées est donné par le document FR2 970 792 A1.

Le document US2010/0174522 décrit un système de test pour tester en parallèle plusieurs systèmes pour un aéronef, dans lequel un réseau maître est fourni afin d'échanger des données entre les différents systèmes d'essai et une unité de contrôle, et où le câblage électrique d'origine est fournis entre les systèmes d'essai afin d'interconnecter directement les systèmes testés.

Le document US2012/0290692 décrit une méthode d'exploitation d'un réseau en anneau comprenant les étapes de configuration du réseau en anneau avec des informations de configuration statique, puis l'échange déterministe de fichiers de données opérationnelles entre une pluralité de noeuds sur le réseau en anneau durant la mise en oeuvre du réseau en anneau conformément aux informations de configuration statique.

### Brève description de l'invention

Dans ce contexte, la présente invention a pour objet la réalisation d'un système de simulation et de test reposant sur un environnement unifié et générique de simulation et de test dédié à l'avionique et propose un modèle d'exécution dynamique pour une architecture matérielle/logicielle hétérogène qui s'appuie sur un protocole de communication de haut niveau.

L'invention est définie par les revendications indépendantes 1 et 12. Les aspects supplémentaires de l'invention sont définis dans les revendications dépendantes. L'expression « mode de réalisation » ne se rapporte qu'à des combinaisons de caractéristiques telles que définies dans les revendications. Dans la présente spécification, quand l'expression « mode de réalisation » se réfère à des combinaisons de caractéristiques qui ne sont pas revendiquées, ladite expression doit alors être interprétée comme se rapportant plutôt à des exemples de réalisation.

Cette solution a pour objet de réaliser une mutualisation des moyens logiciels et matériels de simulation et de test réduisant ainsi la complexité du cycle de vérification et de validation, le temps de développement et le coût de production.

Plus précisément, la présente invention propose un système de simulation et de test qui comporte un premier niveau comportant une couche de communication sous forme d'un réseau informatique en anneau pourvu de noeuds de communication constitués de moyens de routage reliés les uns aux autres, un second niveau autour du premier niveau, ledit second niveau comportant des noeuds de calcul regroupant des moyens de calcul hétérogènes, les noeuds de calcul étant associés aux noeuds de communication de la couche de communication et un troisième niveau constitué par les systèmes réels en tests

Ce réseau permet de réaliser une boucle de simulation à base de modèles virtuels et/ou de test d'équipements avioniques via des interfaces d'entrées/sorties de différents bus avioniques (AFDX, MIL-STD-1553, ARINC 429, etc.).

Avantageusement, chaque noeud de communication est configuré pour assurer la communication avec les noeud voisins et avec le second niveau du système.

Avantageusement, la communication au premier niveau se fait dans un seul sens de circulation de données sur l'anneau.

Selon un mode de réalisation particulier, les moyens de calcul hétérogènes comprennent:
- au moins une station de travail à base d'un ou plusieurs processeurs adaptée à réaliser une exécution séquentielle ou parallèle de modèles avioniques logiciels;
- au moins un premier circuit de calcul reconfigurable adapté à réaliser une exécution parallèle de modèles avioniques matériels;
- une ou plusieurs cartes d'interfaces d'entrées/sorties qui intègrent au moins un second circuit reconfigurable hébergeant une ou plusieurs ressources ou composants logiciels/matériels d'entrées/sorties adaptées à simuler différents bus avioniques tels que AFDX,, MIL-STD-1553, ARINC 429, etc. en sorte de remplacer des cartes d'entrées/sorties spécialisées.

Préférablement, ledit au moins un premier circuit reconfigurable et/ou ledit au moins un second circuit reconfigurable sont de type FPGA.

Avantageusement, le système comportant des moyens adaptés à réaliser une configuration des circuits reconfigurables des cartes d'entrée/sortie en ligne ou hors ligne lors du lancement d'un nouveau projet de test ou l'intégration d'un nouvel équipement dans la boucle de test.

Le système comporte préférablement des moyens adaptés à réaliser une configuration du circuit de calcul reconfigurable hors ligne ou en ligne lors du lancement d'un nouveau projet de test ou via une reconfiguration dynamique lors d'un débordement dans une boucle de simulation ou de test.

Avantageusement, les moyens de routage sont réalisés à partir de routeurs pourvus d'un commutateur assurant la communication inter et intra noeud(s), d'un arbitre adapté à assurer une stratégie d'arbitrage au niveau du commutateur et une synchronisation entre les éléments de calcul et les entrées/sorties, d'un composant reconfigurable hébergeant une ressource ou composant logiciel/matériel horloge pour définir une base de temps commune à l'ensemble des éléments du noeud, un composant mémoire ou une ressource ou composant logiciel/matériel mémoire sur le composant reconfigurable agencée pour stocker des tables de routages afin de router les trames de communication inter et intra noeud(s).

Le réseau informatique en anneau peut en particulier utiliser une ressource bus numérique basé sur le standard «DDS2».

Le système comporte avantageusement un troisième niveau de raccordement de systèmes avioniques en test.

La communication entre des modèles avioniques distribués avec des équipements en test sur le troisième niveau est préférablement assurée par des trames envoyées et reçues par ces modèles.

Plus particulièrement une trame de communication comporte des paramètres incluant: numéro de projet (P), numéro du modèle transmetteur (S); numéro du modèle récepteur (R); drapeau de configuration (F); datation temporelle (T); priorité (P); taille des données (Z); données (D).

Les noeuds routeurs comportent avantageusement un masque de routage global et une table de routage locale.

L'invention concerne en outre un procédé de simulation ou de test au moyen d'un système selon l'invention, le procédé comportant des étapes de lancement de projets et/ou de reconfiguration dynamique de projets initiées par l'envoi de trames de communication sur l'anneau.

### Brève description des dessins

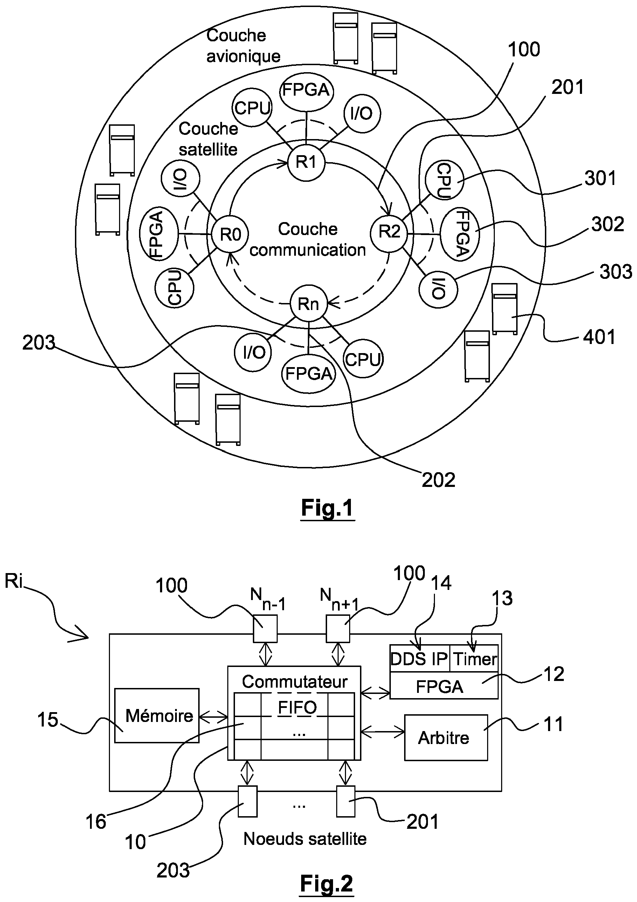

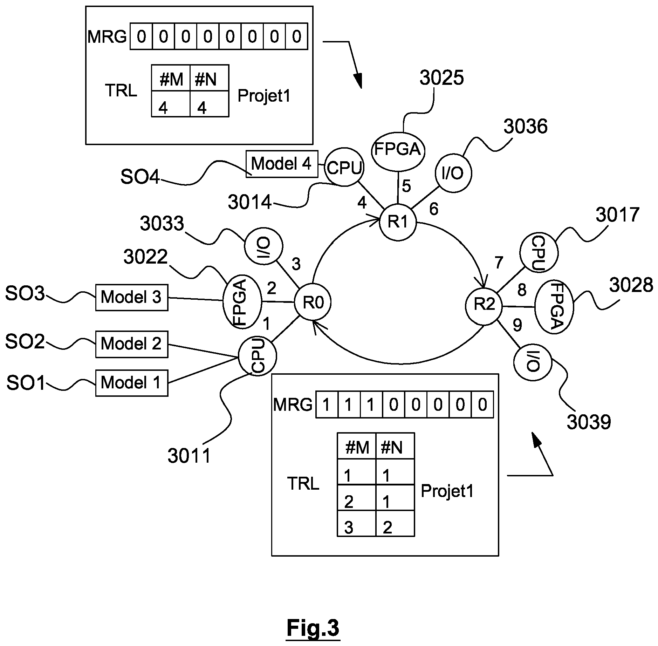

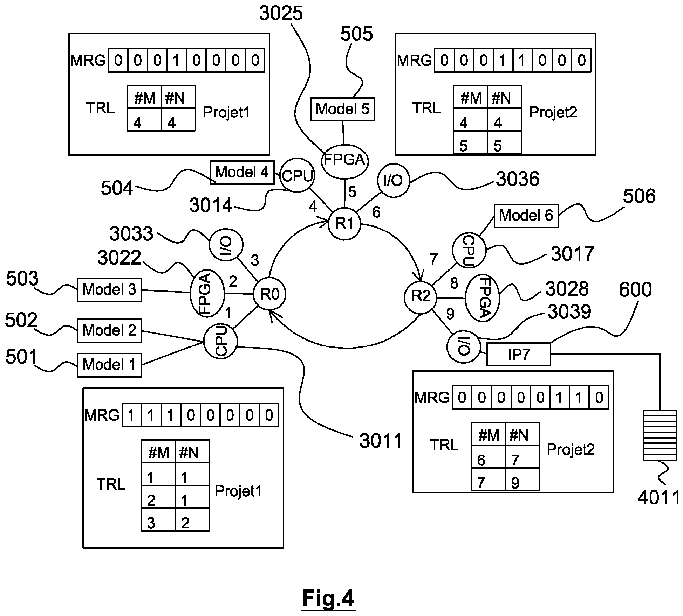

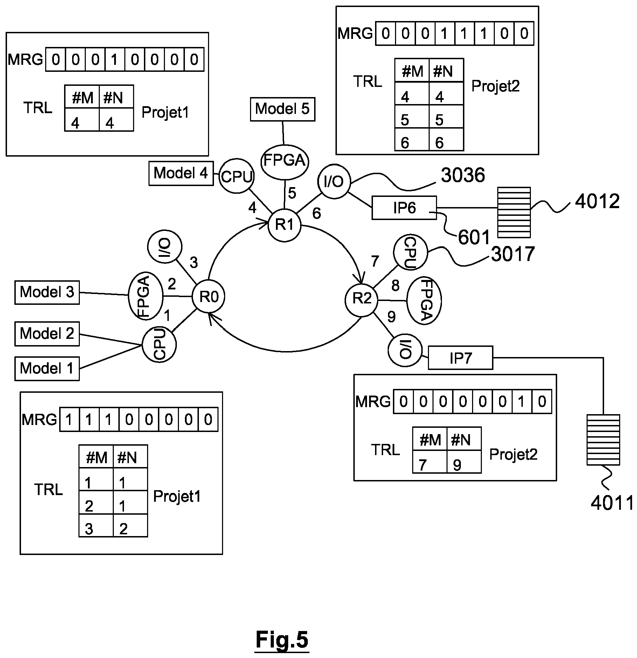

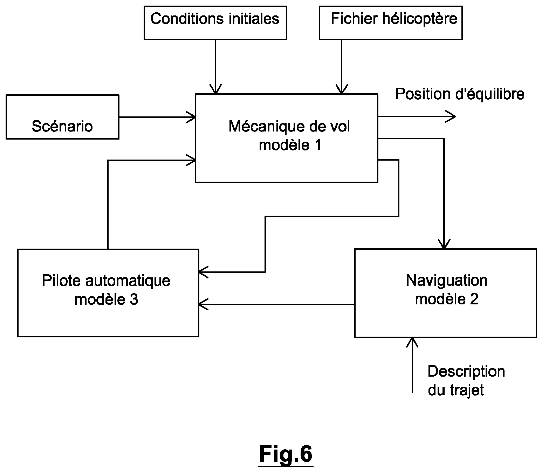

D'autres caractéristiques et avantages de l'invention seront apparents à la lecture de la description qui suit d'un exemple non limitatif de réalisation de l'invention en référence aux dessins qui représentent:
- en figure 1:: une vue schématique de l'architecture d'un banc de test avionique selon l'invention;
- en figure 2:: une vue schématique d'un noeud du banc de test de la figure 1 ;
- en figure 3:: un exemple de réalisation d'un banc selon l'architecture de la figure 1 pour un premier projet;
- en figure 4:: le banc de la figure 3 supportant le premier projet et un second projet;
- en figure 5:: le banc de la figure 3 lors d'une reconfiguration dynamique pour remplacer un modèle par un équipement.
- En figure 6:: un schéma fonctionnel d'une projet de simulation au moyen d'un système selon l'invention.

### Description détaillée de modes de réalisation de l'invention

Comme expliqué plus haut, la présente invention part d'un environnement unifié et générique pour la simulation et le test notamment dédié à des fonctions et systèmes avioniques permettant de contourner les limitations mentionnées ci-dessus. Cet environnement s'appuie sur une architecture matérielle sous forme d'un réseau comportant des noeuds sur lesquels sont raccordés des moyens de calcul hétérogènes (CPU, FPGA et E/Ss) ayant une topologie de communication en anneau.

Ce réseau permet de réaliser une boucle de simulation ou/et de test à base de modèles virtuels ou/et des équipements avioniques via des interfaces d'E/S de différents bus avioniques (AFDX, MIL-STD-1553, ARINC 429, etc.).

L'invention propose un modèle d'exécution dynamique pour cette architecture matérielle contrôlé par un protocole de communication et de configuration de haut niveau.

Le modèle d'exécution permet une adaptation en ligne de l'environnement pour supporter plusieurs projets de simulation et/ou de tests issus de différentes phases du cycle de vérification et de validation ou de plusieurs gammes d'aéronefs tels que des hélicoptères. La reconfiguration dynamique est un autre attrait du modèle d'exécution pour gérer les débordements dans les temps de calcul ou pour remplacer un modèle virtuel par l'équipement réel afin d'avancer dans le cycle de vérification et de validation. Le modèle d'exécution offre le partage de ressources matérielles et logicielles entre plusieurs projets de simulation et/ou de tests présentant ainsi une grande mutualisation des moyens de test et par la suite une réduction des coûts associés.

Le protocole de communication et de configuration sur lequel s'appuie le modèle d'exécution est générique et ouvert. Il est construit à un niveau assez abstrait indépendant des technologies de transport existantes, permettant ainsi une intégration aisée des technologies émergentes et une diffusion du protocole vers les producteurs des outils de simulation et de test. L'encapsulation du protocole dans les composants matériels et logiciels (hardware/software) de simulation et de test permet d'assurer le caractère évolutif de ce protocole.

L'environnement unifié et générique pour la simulation et le test offert par l'architecture matérielle hétérogène, le modèle d'exécution dynamique et le protocole générique de communication et de configuration de l'invention est une innovation notable dans le domaine des systèmes de tests d'intégration avioniques.

La figure 1 illustre l'architecture du banc de tests avioniques générique de l'invention. Les composants matériels de cette architecture sont répartis sur trois niveaux hiérarchiques. le troisième niveau étant dédié à des équipements en test. Le premier niveau représente la couche de communication en anneau 100 où des noeud constitués par des routeurs R0, R1, ..., Rn vont assurer la communication avec le noeud voisin dans un seul sens de circulation sur l'anneau et aussi avec le deuxième niveau de hiérarchie local. Ce dernier appelé couche satellite, est formé d'un ensemble de ressources, appelées de manière générale noeuds satellites, telles que :
Un nombre de stations de travail 301 par exemple à base de processeurs multi coeurs (CPU) permettant une exécution séquentielle ou parallèle des modèles avioniques logiciels.

Un nombre de circuits de calcul 302 de type FPGA (field programmable gate array c'est à dire circuit intégré pré-diffusé programmable en français) permettant une exécution parallèle des modèles avioniques Hardware. La configuration de ces circuits FPGA peut être assurée hors ligne ou en ligne lors du lancement d'un nouveau projet de test ou via une reconfiguration dynamique lors d'un débordement dans une boucle de simulation ou de test.

Un nombre de cartes d'interfaces d'entrées/sorties 303 qui intègrent un circuit FPGA hébergeant une ou plusieurs composants logiciel/matériel (bloc « IP ») d'entrées/sorties (différents bus avioniques tels que AFDX, MIL-STD-1553, ARINC 429, etc.) permettant de remplacer les cartes d'entrées/sorties spécialisées dans les architectures de l'art antérieur et par conséquence offrant une mutualisation du matériel de test. La configuration de ce circuit FPGA peut être assurée en ligne ou hors ligne lors du lancement d'un nouveau projet de test ou l'intégration d'un nouvel équipement dans la boucle de test.

Sur le troisième niveau vont se placer les équipements réels à tester 401, ces équipement se connectant sur les cartes d'interface entrées/sorties 303.

Le choix d'une topologie de réseau en anneau pour connecter les noeuds de routeurs R0, R1, ... , Rn est justifié par le domaine d'application où il s'agit d'une boucle de modèles, notamment de modèles décrivant l'ensemble des fonctionnalités d'un banc de tests qui s'exécute de façon cyclique et périodique.

L'architecture d'un routeur Ri est illustrée à la figure 2. Il comporte un commutateur rapide ou switch 10 assurant la communication inter et intra noeud(s), un arbitre 11 assurant la stratégie d'arbitrage au niveau du commutateur et la synchronisation entre les éléments de calcul et les entrées/sorties. Il comporte en outre un composant programmable 12 par exemple de type FPGA hébergeant un ensemble de ressources de type composants logiciel/matériel (appelés notamment blocs « IP ») tels qu'une horloge 13 ou timer pour définir une base de temps commune à l'ensemble des éléments du noeud, une ressource telle qu'un composant logiciel/matériel (bloc « IP ») bus numérique 14 basé sur le standard «DDS2» Data Distribution Service service de distribution de données où DDS est un standard spécifié par l'OMG (Object Management Group) dont le rôle est de proposer une technologie évoluée d'échanges de données via un réseau. Un DDS est de type middleware (qui se traduit par logiciel médiateur ou interlogiciel), il favorise les interactions entre des applications à travers un réseau. Les applications disposent d'interfaces API (application programming interface soit interface de programmation d'applications) leur assurant l'utilisation des services offerts.

L'arbitre 11 est instancié soit par un processeur du routeur soit par une zone du FPGA 12 du routeur.

Un composant mémoire 15 ou une ressource mémoire ou composant logiciel/matériel mémoire de type RAM sur le FPGA est prévu pour stocker des tables de routages afin de router les trames de communication inter et intra noeud(s).

Un masque de routage global MRG et une table de routage locale TRL seront définis au niveau de chaque noeud et pour chaque projet comme suit :
Le masque de routage global est adressé bit à bit par le numéro du modèle destination, sa valeur booléenne spécifie l'aspect local ou distant du modèle destinataire.

Chaque entrée de la table de routage locale d'un projet est composée du couple numéro du modèle, numéro du noeud local associé à ce modèle.

La communication entre des modèles avioniques distribués sur l'architecture de l'invention ainsi qu'avec des équipements sous test est assurée par des trames de haut niveau envoyées et reçues par ces modèles. Une trame de communication est définie par un nombre de paramètres comme suit :
Numéro de projet (P),
Numéro du modèle transmetteur (S);
Numéro du modèle récepteur (R);
Un flag ou drapeau de configuration (F);
Datation temporelle (T);
Priorité (P);
Taille des données (Z);
Données (D).

Une trame de communication est par défaut destinée à un seul destinataire et dans un tel cas un bit de broadcast ou diffusion B du drapeau/flag «F» est égal à zéro.

En se basant sur le masque de routage global et les tables de routage, la trame sera acheminée par un routeur soit vers un routeur voisin soit vers un noeud satellite une fois arrivée sur le noeud destination. L'environnement de simulation et de test est conçu pour supporter plusieurs projets en parallèle avec un partage de ressources.

Une FIFO (first in first out soit premier entré premier sorti) 16 représentée schématiquement à la Figure 2 est définie à l'entrée de chaque noeud satellite pour gérer l'accès simultané à la même ressource. Plusieurs trames peuvent être ordonnancées selon le champ «Priorité» et les contraintes temporelles de chaque projet.

La reconfiguration en ligne de l'outil est possible et plusieurs cas de reconfiguration peuvent être identifiés dans notre environnement de simulation et de test pour gérer le lancement de nouveaux projets. Parmi ces cas se trouvent le remplacement dynamique d'un modèle par un autre ou par un équipement et la suppression ou l'arrêt d'un modèle ou d'un projet existant. L'opération de reconfiguration est gérée par le noeud source de l'anneau où une bibliothèque de modèles et de ressources logicielles et matérielles est disponible.

Nous allons détailler maintenant les différents cas de reconfiguration ainsi que la liste d'actions associées. Le flag (drapeau) de configuration «F» sera utilisé pour identifier chaque cas (six configurations identifiées par 6 valeurs de flag de F1 à F6).

Un premier cas est constitué par une configuration de nouveaux modèles sur un noeud routeur: Il peut s'agir d'une implémentation matérielle d'une nouvelle ressource sur le composant FPGA tel qu'une ressource de type composant logiciel/matériel (bloc « IP ») «timer» ou «DDS». Il peut s'agir aussi d'une configuration logicielle du noeud telle que la stratégie d'ordonnancement au niveau du routeur adaptée à gérer le partage de ressources.

Il y a lieu d'identifier dans le protocole de configuration de haut niveau les information suivantes:
Le champ «P» qui identifie le numéro du modèle ou de la ressource,
Le champ «S» qui correspond au noeud source de l'anneau;
Le champ «R» qui spécifie le noeud routeur destinataire;
Le champ «D» qui contient la référence vers la configuration logicielle ou matérielle (adresse d'un fichier bitstream ou binaire stocké en mémoire).

Un deuxième cas concerne la configuration de nouveaux modèles sur un noeud satellite: l'objectif est par exemple de placer soit un nouveau modèle avionique virtuel sur une station de travail 301 ou une unité de calcul 302 ou bien une ressource de type composant logiciel/matériel (bloc « IP ») d'entrée/sortie I/O sur une carte d'interface 303 pour communiquer avec un équipement 401. Pour ce faire, une trame de configuration sera envoyée à tous les noeuds routeurs R0, ..., Rn en spécifiant les champs suivants :
Le champ «P» qui identifie le numéro du projet auquel appartient le modèle ou la ressource,
Le champ «S» qui correspond au numéro du modèle,
Le champ «R» qui spécifie le numéro du noeud satellite destinataire,
Le champ «D» qui contient la référence vers la configuration logicielle ou matérielle (adresse d'un fichier bitstream ou binaire stocké en mémoire).
Suite à cette trame de reconfiguration, le masque de routage global et la table de routage locale du projet correspondant seront mis à jour au niveau du noeud routeur associé au modèle.

Un troisième cas concerne le lancement de nouveaux projets de test ou de simulation: après la configuration de l'ensemble des modèles constituant un projet de simulation ou de test, nous avons besoin d'une trame spécifique pour lancer le projet. Les informations pertinentes dans ce cas sont les suivantes :
Le champ «P» qui identifie le numéro du projet à lancer,
Le champ «T» qui spécifie la contrainte temporelle à respecter pour un cycle de simulation ou de test.
Cette trame sera diffusée à l'ensemble des noeuds de l'anneau et aura comme effet l'exécution de tous les modèles appartenant au projet. Par ailleurs, le lancement d'un nouveau projet déclenchera la supervision temps réel de l'exécution afin de vérifier que la contrainte temporelle est bien respectée.

Un quatrième cas correspond à l'arrêt d'un projet existant. Après la fin d'un projet de simulation ou de test, nous avons besoin d'arrêter un projet dans une première perspective de le relancer de nouveau avec un autre jeu de données que nous appelons «scenario» ou bien de le supprimer et libérer des ressources matérielles de l'anneau dans une deuxième perspective. Un projet de simulation ou de test peut aussi être arrêté si la contrainte temporelle n'est pas respectée.

L'arrêt d'un projet engendre la suspension de l'exécution des modèles associés. Le champ «P» identifiant le numéro du projet à arrêter doit être spécifié dans la trame pour cette configuration.

Un cinquième cas correspond à la suppression d'un projet existant. L'objectif est alors de libérer les ressources matérielles de l'anneau afin qu'elles puissent être utilisées par un autre projet. Cette action permet de supprimer le masque de routage global et la table de routage locale du projet correspondant au niveau de chaque noeud routeur de l'anneau. Le champ «P» identifiant le numéro du projet à supprimer est l'information pertinente pour cette configuration.

Le sixième cas correspond à la suppression d'un modèle existant : le remplacement d'un modèle virtuel existant par un autre modèle ou par l'équipement matériel correspondant nécessite tout d'abord la suppression de ce modèle et la mise à jour du masque de routage global et de la table de routage locale au niveau du noeud routeur associé. Les deux champs «P» et «S» identifiant respectivement le numéro du projet et le numéro du modèle sont suffisants pour supprimer un modèle existant. Le nouveau modèle ou équipement possédera dans le projet le même numéro que celui de l'ancien modèle. Il sera lancé par une trame respectant la configuration d deuxième cas.

Un aspect important à considérer est la gestion du temps. La gestion du temps est un aspect essentiel dans un banc de simulation et de test pour satisfaire des besoins de temps réel et la datation temporelle des entrées/sorties. Dans la présente invention, un projet de test ou de simulation peut être distribué sur l'ensemble des noeuds de l'anneau. La synchronisation de temps entre ces noeuds est assurée par le noeud source de l'anneau qui se charge de diffuser de façon cyclique une trame de temps pour la mise à jour des horloges (timers) locales.

Cette trame est identifiée par une valeur particulière du drapeau/flag de configuration «F». L'information pertinente à diffuser est le champ «T» qui spécifie la valeur actualisée du temps. La supervision en ligne de chaque projet permet de vérifier le respect de la contrainte temporelle.

La figure 3 est une illustration d'un exemple de réalisation d'un système de banc de simulation et de test générique en se basant sur l'architecture proposée dans la figure 1.

Le système comprend trois noeuds équipés de routeurs R0, R1, R2 possédant chacun une station de travail 301 (3011, 3014, 3017) à base d'un processeur multi-coeurs, un circuit reconfigurable 302 FPGA (3022, 3025, 3028) et une carte d'interface d'E/S 303 (3033, 3036, 3039). Après la connexion des noeuds satellites sur l'anneau, ils seront identifiés par un numéro unique au niveau de l'anneau par construction architecturale. Nous considérons comme un premier exemple le déploiement d'un projet P1 présentant une boucle de simulation d'un appareil A. Le projet P1 contient 4 modèles 501, 502, 503, 504 distribués sur plusieurs noeuds comme illustré dans la Figure 3, à savoir les modèles model1 501, model2, 502 sur la station de travail 3011 du noeud satellite CPU du routeur R0, le modèle model3, 503 sur le circuit de calcul 3022 du noeud satellite FPGA du routeur R1 et le modèle Model4, 504 sur la station de travail 3014 du noeud satellite CPU du routeur R1. Afin de démarrer ce projet de simulation, 5 trames de configuration comprenant les données numéro de projet (P), numéro du modèle transmetteur (S), numéro du modèle récepteur (R), un flag ou drapeau de configuration (F), datation temporelle (T), priorité (P), taille des données (Z), données (D) comme défini précédemment sont nécessaires.
Les trames donnent:
Configurer le modèle 1 : (1, 1, 1, F2, 25ms, 5, 12ko, @modei1)
Configurer le modèle 2 :(1, 2, 1, F2, 25ms, 5, 71ko, @model2)
Configurer le modèle 3 «1, 3, 2, F2, 25ms, 5, 68ko, @model3)
Configurer le modèle 4 : (1, 4, 4, F2, 25ms, 5, 23ko, @model4)
Lancer le projet P1 : (1, x, x, F3, 25ms, x, x, x)

Après le lancement de ces configurations, le masque de routage global MRG ainsi que la table de routage locale TRL sont mis à jour au niveau des routeurs R1 et R2 comme le montre la Figure 3 représentant le déploiement du projet P1.

Dans un deuxième exemple représenté en figure 4, nous considérons un deuxième projet P2 présentant une boucle de test d'un appareil 4011. Cette boucle est formée de trois modèles et d'un équipement. Le projet P2 partage avec P1 le modèle 4.

Le modèle 5 model5, 505 est sur le circuit de calcul 3025 du noeud satellite FPGA du routeur R1 et le modèle 6, Model6, 506 sur la station de travail 3017 du noeud satellite CPU du routeur R2. Le lancement de ce nouveau projet sur le banc de simulation et de test se fait en ligne en utilisant les trames de configuration suivantes :
Configurer le modèle 5 : (2, 5, 5, F2, 20ms, 4, 16ko, @model5)
Configurer le modèle 6 : (2, 6, 7, F2, 20ms, 4, 91ko, @model6)
Configurer le modèle 7 : (2, 7, 9, F2, 20ms, 4, 38ko, @model7)
Lancer le projet P2 : (2, x, x, F3, 20ms, x, x, x).

Le composant logiciel/matériel I/O IP7, 600 permet la communication avec l'appareil 4011.

Cet exemple montre le support multi-projets de simulation et de test du système proposé avec une configuration aisée en ligne de l'environnement. Pour des hélicoptères notamment, le partage de ressources permet une mutualisation des moyens de simulation et de test entre plusieurs gammes d'hélicoptères ou bien entre les différentes phases de vérification et de validation.

Dans un troisième exemple représenté en figure 5, nous nous intéressons à la reconfiguration dynamique d'un modèle existant afin de le remplacer par l'équipement réel. Une telle procédure nous permet d'avancer progressivement dans le cycle de vérification et de validation et atteindre l'objectif de validation du système complet au sol. Nous considérons le remplacement du modèle 6 du projet P2 par l'équipement réel 4012 branché sur le noeud satellite I/O 3036 du routeur R1. La ressource ou composant logiciel/matériel I/O IP6, 601 permet la communication avec l'appareil 4012.

Les autres modèles du projet P2 demeurent à leur localisation respective. Pour réaliser cette modification, il suffit d'utiliser les deux trames de configuration suivantes :
Supprimer le modèle 6 : (2, 6, x, F6, x, x, x, x), configurer le nouvel équipement : (2, 6, 6, F2, 20ms, 4, 91ko, @IP6).

Bien que d'autres topologies de réseau peuvent montrer leur efficacité pour des graphes de tâches irréguliers, le choix d'une topologie de réseau en anneau pour connecter les noeuds de calcul est un exemple de liaison garantissant des délais de communication déterministes lors de l'exécution d'une boucle de simulation ou de test de façon distribuée sur le réseau de calcul.

Un avantage de la structure est aussi que n'importe quel noeud de l'anneau peut être interfacé avec un superviseur en charge le lancement et l'exécution des tests.

Plusieurs avantages peuvent être tirés à partir de l'environnement unifié et générique de simulation et de test offert par l'architecture matérielle hétérogène, le modèle d'exécution dynamique et le protocole de communication et de configuration de l'invention:
- un environnement de simulation et de test générique et versatile supportant plusieurs projets simultanément correspondant à différentes phases de vérification et de validation et gammes d'hélicoptères, présentant ainsi une grande mutualisation des moyens de simulation et de test,
- un environnement adaptatif permettant l'assemblage de composants en ligne pour lancer de nouveaux projets en ligne;
- un environnement évolutif basé sur le concept de modèle hardware, software et I/O;
- un environnement avec un modèle d'exécution dynamique pour gérer les débordements dans les temps de calcul et pour remplacer un modèle virtuel par un autre ou par l'équipement réel pendant l'exécution, permettant ainsi une intégration aisée des technologies émergentes;
- un environnement contrôlé par un protocole de communication et de configuration indépendant des technologies de transport existantes, et
- un environnement contrôlé par un protocole de communication et de configuration ouvert dans une perspective de le diffuser vers les producteurs des outils de simulation et de test et de s'orienter vers une proposition d'un standard de communication pour les outils de simulation et de test dans le domaine avionique.

L'exploitation efficace des performances de l'architecture proposée nécessite la disponibilité d'une bibliothèque de modèles avioniques éligibles pour une implémentation logicielle sur CPU et matérielle sur FPGA. Le transcodage d'un modèle logiciel (Software) en matériel (Hardware) doit passer nécessairement par une phase manuelle ou semi-automatique. De même pour les équipements matériels, il est nécessaire d'avoir les ressources d'entrées/sorties permettant l'échange de données selon un protocole particulier de bus avioniques. L'exploitation efficace des performances du banc générique de simulation et de test et en particulier la reconfiguration en ligne nécessite des algorithmes de mappage rapides et performants pour gérer la distribution des modèles sur l'anneau.

Lors d'une session de test et/ou de simulation, il est nécessaire de simuler le comportement global de l'appareil concerné ainsi que tous les paramètres environnementaux comme les équipements non présents, les conditions climatiques, l'environnement géographique dans lequel va évoluer l'hélicoptère et tout autre paramètre nécessaire. La figure 6 présente une version simplifiée d'une boucle de test nécessaire incluant trois modèles: la mécanique de vol, la navigation ainsi que le pilote automatique. Cette boucle est implémentée sur un système selon l'invention en chargeant les modèles sur les moyens de calcul au travers des différents routeurs.

L'anneau permet de faire passer des données de la simulation. Par exemple, un modèle model1 sur R0 va pouvoir communiquer des données avec l'appareil branché sur l'I/O de R2. Il est toutefois judicieux de placer des systèmes qui communiquent beaucoup sur un même routeur, ceci afin d'éviter de saturer les réseau.

Par ailleurs le système en anneau de l'invention est modulaire dans le sens où il est envisageable d'ajouter des routeurs/satellites en fonction de la complexité de l'appareil à tester en rajoutant des routeurs dans la boucle du premier niveau de façon statique en modifiant les tables.

L'invention a été décrite plus particulièrement en rapport avec des hélicoptères mais peut s'appliquer à tout système complexe de bancs de test et de simulation.

## Revendications

1. Système de simulation et de test **caractérisé en ce qu'**il comporte un premier niveau (100) comportant une couche de communication sous forme d'un réseau informatique en anneau pourvu de noeuds de communication constitués de moyens de routage (R0, R1, R2, ..., Rn) reliés les uns aux autres, un second niveau autour du premier niveau (100), ledit second niveau comportant des noeuds de calcul regroupant des moyens de calcul hétérogènes, les noeuds de calcul étant associé aux noeuds de communication de la couche de communication, et un troisième niveau constitué par les systèmes réels en test (401), lesdits moyens de calcul hétérogènes comprenant :
- au moins une station de travail à base d'un ou plusieurs processeurs (301) adaptée à réaliser une exécution séquentielle ou parallèle de modèles avioniques logiciels ;
- au moins un premier circuit de calcul (302) reconfigurable adapté à réaliser une exécution parallèle de modèles avioniques matériels ;
- une ou plusieurs cartes d'interfaces d'entrées/sorties (303) qui intègrent au moins un second circuit reconfigurable hébergeant une ou plusieurs ressources d'entrées/sorties adaptées à simuler différents bus avioniques tels que AFDX, MIL-STD-1553, ARINC 429, etc. en sorte de remplacer des cartes d'entrées/sorties spécialisées,
lesdits moyens de routage (R0, R1, R2, ..., Rn) étant réalisés à partir de routeurs pourvus d'un commutateur (10) assurant la communication inter et intra noeud(s), d'un arbitre (11) adapté à assurer une stratégie d'arbitrage au niveau du commutateur (10) et une synchronisation entre les éléments de calcul et les entrées/sorties, d'un composant reconfigurable (12) hébergeant une ressource horloge (13) pour définir une base de temps commune à l'ensemble des éléments du noeud, un composant mémoire (15) ou une ressource mémoire sur le composant reconfigurable (12) agencée pour stocker des tables de routages afin de router les trames de communication inter et intra noeud(s).

2. Système de simulation et de test selon la revendication 1 pour lequel chaque noeud de communication est configuré pour assurer la communication avec les noeud voisins et avec le second niveau du système.

3. Système de simulation et de test selon la revendication 1 ou 2 pour lequel la communication au premier niveau se fait dans un seul sens de circulation de données sur l'anneau.

4. Système de simulation et de test selon l'une quelconque des revendications précédentes pour lequel ledit au moins un premier circuit reconfigurable et/ou ledit au moins un second circuit reconfigurable sont de type FPGA.

5. Système de simulation et de test selon la revendication 4 comportant des moyens adaptés à réaliser une configuration des circuits reconfigurables des cartes d'entrée/sortie (303) en ligne ou hors ligne lors du lancement d'un nouveau projet de test ou l'intégration d'un nouvel équipement dans la boucle de test.

6. Système de simulation et de test selon la revendication 4, ou 5 comportant des moyens adaptés à réaliser une configuration du circuit de calcul (302) reconfigurable hors ligne ou en ligne lors du lancement d'un nouveau projet de test ou via une reconfiguration dynamique lors d'un débordement dans une boucle de simulation ou de test.

7. Système de simulation et de test selon l'une quelconque des revendications précédentes pour lequel le réseau informatique en anneau utilise une ressource bus numérique basé sur le standard «DDS2».

8. Système de simulation et de test selon l'une quelconque des revendications précédentes **caractérisé en ce qu'**il comporte un troisième niveau de raccordement de systèmes avioniques en test.

9. Système de simulation et de test selon la revendication 8 pour lequel la communication entre des modèles avioniques distribués avec des équipements en test (401) sur le troisième niveau est assurée par des trames envoyées et reçues par ces modèles.

10. Système de simulation et de test selon la revendication 9 pour lequel une trame de communication comporte des paramètres incluant: numéro de projet (P), numéro du modèle transmetteur (S); numéro du modèle récepteur (R); drapeau de configuration (F); datation temporelle (T); priorité (P); taille des données (Z); données (D).

11. Système de simulation et de test selon l'une quelconque des revendications précédentes pour lequel les noeuds routeurs comportent un masque de routage global et une table de routage locale.

12. Procédé de simulation ou de test au moyen d'un système selon l'une quelconque des revendications précédentes **caractérisé en ce qu'**il comporte des étapes de lancement de projets et/ou de reconfiguration dynamique de projets initiées par l'envoi de trames de communication sur l'anneau.

## Patentansprüche

1. Simulations- und Testsystem, **dadurch gekennzeichnet, dass** es eine erste Ebene (100), die eine Kommunikationsschicht in Form eines EDV-Ringnetzwerks aufweist, das mit Kommunikationsknoten versehen ist, die aus miteinander verbundenen Routing-Einrichtungen (R0, R1, R2, ..., Rn) bestehen, eine zweite Ebene um die erste Ebene (100) herum, wobei die zweite Ebene Rechenknoten aufweist, die heterogene Recheneinrichtungen umfassen, wobei die Rechenknoten den Kommunikationsknoten der Kommunikationsschicht zugeordnet sind, und eine dritte Ebene aufweist, die aus den realen Systemen (401) im Test besteht, wobei die heterogenen Recheneinrichtungen enthalten:
- mindestens eine Arbeitsstation auf der Basis eines oder mehrerer Prozessoren (301), die geeignet ist, eine sequentielle oder parallele Ausführung von Software-Avionikmodellen durchzuführen;
- mindestens einen ersten rekonfigurierbaren Rechenschaltkreis (302), der geeignet ist, eine parallele Ausführung von Hardware-Avionikmodellen durchzuführen;
- eine oder mehrere Eingangs-/Ausgangs-Schnittstellenkarten (303), in die mindestens ein zweiter rekonfigurierbarer Schaltkreis integriert ist, in dem eine oder mehrere Eingangs-/Ausgangs-Ressourcen untergebracht sind, die geeignet sind, verschiedene Avionik-Busleitungen wie AFDX, MIL-STD-1553, ARINC 429, usw. zu simulieren, um spezialisierte Eingangs-/Ausgangs-Karten zu ersetzen,
wobei die Routing-Einrichtungen (R0, R1, R2, ..., Rn) ausgehend von Routern hergestellt werden, die mit einem Schalter (10), der die Kommunikation zwischen und innerhalb von Knoten gewährleistet, einem Arbiter (11), der geeignet ist, eine Arbitrationsstrategie auf der Ebene des Schalters (10) und eine Synchronisation zwischen den Rechenelementen und den Eingängen/Ausgängen zu gewährleisten, einem rekonfigurierbaren Bauteil (12) versehen sind, in dem eine Taktgeber-Ressource (13), um eine der Gesamtheit der Elemente des Knotens gemeinsame Zeitbasis zu definieren, ein Speicherbauteil (15) oder eine Speicherressource im rekonfigurierbaren Bauteil (12) untergebracht sind, die eingerichtet ist, Routingtabellen zu speichern, um die Kommunikationsrahmen zwischen den und innerhalb der Knoten zu routen.

2. Simulations- und Testsystem nach Anspruch 1, bei dem jeder Kommunikationsknoten konfiguriert ist, die Kommunikation mit den benachbarten Knoten und mit der zweiten Ebene des Systems zu gewährleisten.

3. Simulations- und Testsystem nach Anspruch 1 oder 2, bei dem die Kommunikation auf der ersten Ebene in nur einer Datenflussrichtung auf dem Ring erfolgt.

4. Simulations- und Testsystem nach einem der vorhergehenden Ansprüche, bei dem der mindestens eine erste rekonfigurierbare Schaltkreis und/oder der mindestens eine zweite rekonfigurierbare Schaltkreise vom Typ FPGA sind.

5. Simulations- und Testsystem nach Anspruch 4, das Einrichtungen aufweist, die geeignet sind, eine Konfiguration der rekonfigurierbaren Schaltkreise der Eingangs-/Ausgangs-Karten (303) online oder offline beim Start eines neuen Testprojekts oder der Aufnahme einer neuen Ausrüstung in die Testschleife durchzuführen.

6. Simulations- und Testsystem nach Anspruch 4 oder 5, das Einrichtungen aufweist, die geeignet sind, eine Konfiguration des rekonfigurierbaren Rechenkreises (302) offline oder online beim Start eines neuen Testprojekts oder über eine dynamische Rekonfiguration bei einem Überlauf in einer Simulations- oder Testschleife durchzuführen.

7. Simulations- und Testsystem nach einem der vorhergehenden Ansprüche, bei dem das EDV-Ringnetzwerk eine digitale Bus-Ressource basierend auf dem Standard «DDS2» verwendet.

8. Simulations- und Testsystem nach einem der vorhergehenden Ansprüche, **dadurch gekennzeichnet, dass** es eine dritte Ebene zum Anschluss von Avioniksystemen im Test aufweist.

9. Simulations- und Testsystem nach Anspruch 8, bei dem die Kommunikation zwischen verteilten Avionikmodellen mit Ausrüstungen (401) im Test auf der dritten Ebene von Rahmen gewährleistet wird, die von diesen Modellen gesendet und empfangen werden.

10. Simulations- und Testsystem nach Anspruch 9, bei dem ein Kommunikationsrahmen Parameter aufweist, die umfassen: Projektnummer (P), Nummer des übertragenden Modells (S); Nummer des empfangenden Modells (R); Konfigurationsflag (F); zeitliche Datierung (T); Priorität (P); Größe der Daten (Z); Daten (D).

11. Simulations- und Testsystem nach einem der vorhergehenden Ansprüche, bei dem die Routerknoten eine globale Routingmaske und eine lokale Routingtabelle aufweisen.

12. Simulations- oder Testverfahren mittels eines Systems nach einem der vorhergehenden Ansprüche, **dadurch gekennzeichnet, dass** es Schritte des Starts von Projekten und/oder einer dynamischen Rekonfiguration von Projekten aufweist, die durch das Senden von Kommunikationsrahmen auf dem Ring initiiert werden.

## Claims

1. Simulation and test system, **characterized in that** it comprises a first level (100) comprising a communication layer in the form of a ring computer network provided with communication nodes consisting of routing means (R0, R1, R2, ..., Rn) linked together, a second level around the first level (100), the said second level comprising calculation nodes grouping together heterogeneous calculation means, the calculation nodes being associated with the communication nodes of the communication layer, and a third level consisting of the actual systems under test (401), the said heterogeneous calculation means comprising:
- at least one work station based on one or more processors (301) suitable for carrying out a sequential or parallel execution of software avionics models;
- at least one first reconfigurable calculation circuit (302) suitable for carrying out a parallel execution of hardware avionics models;
- one or more input/output interface boards (303) which integrate at least one second reconfigurable circuit hosting one or more input/output resources suitable for simulating various avionics buses such as AFDX, MIL-STD-1553, ARINC 429, etc. so as to replace specialized input/output boards,
the said routing means (R0, R1, R2, ..., Rn) being embodied on the basis of routers provided with a switch (10) ensuring inter and intra node(s) communication, of an arbitrator (11) suitable for ensuring an arbitration strategy at the level of the switch (10) and a synchronization between the calculation elements and the inputs/outputs, of a reconfigurable component (12) hosting a clock resource (13) for defining a time base common to the whole set of elements of the node, a memory component (15) or a memory resource on the reconfigurable component (12), designed to store routing tables so as to route the inter and intra node(s) communication frames.

2. Simulation and test system according to Claim 1, for which each communication node is configured to ensure communication with the neighbouring nodes and with the second level of the system.

3. Simulation and test system according to Claim 1 or 2, for which communication at the first level is done in a single direction of travel of data around the ring.

4. Simulation and test system according to any one of the preceding claims, for which the said at least one first reconfigurable circuit and/or the said at least one second reconfigurable circuit are of FPGA type.

5. Simulation and test system according to Claim 4, comprising means suitable for carrying out a configuration of the reconfigurable circuits of the input/output boards (303) on-line or off-line during the launching of a new test project or the integration of a new device into the test loop.

6. Simulation and test system according to Claim 4 or 5, comprising means suitable for carrying out a configuration of the reconfigurable calculation circuit (302) off-line or on-line during the launching of a new test project or via a dynamic reconfiguration during an overflow in a simulation or test loop.

7. Simulation and test system according to any one of the preceding claims, for which the ring computer network uses a digital bus resource based on the "DDS2" standard.

8. Simulation and test system according to any one of the preceding claims, **characterized in that** it comprises a third level for hooking up avionics systems under test.

9. Simulation and test system according to Claim 8, for which communication between avionics models distributed with devices under test (401) on the third level is ensured by frames sent and received by these models.

10. Simulation and test system according to Claim 9, for which a communication frame comprises parameters including: project number (P), number of the transmitter model (S); number of the receiver model (R); configuration flag (F); temporal date-stamping (T); priority (P); size of the data (Z); data (D).

11. Simulation and test system according to any one of the preceding claims, for which the router nodes comprise a global routing mask and a local routing table.

12. Method of simulation or testing by means of a system according to any one of the preceding claims, **characterized in that** it comprises steps of launching projects and/or of dynamically reconfiguring projects, which steps are initiated by sending communication frames on the ring.
